# EUROPEAN PATENT SPECIFICATION

(11) **EP 0 530 159 B1**
(45) Date of publication and mention of the grant of the patent: **02.07.1997**
(21) Application number: 92830458.3
(22) Date of filing: 27.08.1992
(51) Int. Cl.: H03K 17/22

(54) **Zero-consumption power-on reset circuit**
Einschaltrücksetzschaltung ohne Stromverbrauch
Circuit de remise à zéro à la mise sous tension à consommation nulle

(30) Priority: 30.08.1991 IT VA910026
(43) Date of publication of application: 03.03.1993
(73) Proprietor: SGS-THOMSON MICROELECTRONICS s.r.l., 20041 Agrate Brianza (Milano) (IT)
(72) Inventor: Pascucci, Luigi, I-20099 Sesto S. Giovanni (IT); Olivo, Marco, I-24100 Bergamo (IT)
(74) Representative: Pellegri, Alberto

(56) References cited:
- EP-A- 0 150 480
- EP-A- 0 323 367
- US-A- 4 885 476

## Description

In integrated circuits and particularly in micrologics, there is often the necessity of integrating specific circuits capable of ensuring the resetting of all the functional structures of the integrated device to a certain state whenever power is switched on, independently of the manner in which the supply voltage raises from ground potential to the nominal supply voltage, in order to prevent the occurrence of unlicit or uncontemplated configurations, which may cause malfunctioning and sometime latching of the whole device.

So-called power-on reset circuits, commonly referred to by the acronym POR, preside to this function. These circuits are capable of generating a resetting pulse of predetermined characteristics upon switching on the integrated circuit.

Generally, these POR circuits have an architecture which implies static current paths between the supply nodes and, though these power dissipating static current paths may normally have a relatively high impedance, the persistence of a nonnegligeable static power consumption may not be compatible with design specifications of CMOS integrated devices, which typically have a null static consumption.

Moreover these POR circuits may become themeselves a cause of malfunctioning if accidentally stimulated by internal or external transient events, e.g. noise induced by the switching of output buffers and the like.

EP-A-0 150 480-A3 discloses a POR, pulse generator free of static current paths. An RC network is used for sensing the supply voltage and the circuit uses a latch circuit delay network and an output amplifier constituted by two inverter stages in cascade, as set out in the preamble portion of Claim 1.

### OBJECTIVE AND SUMMARY OF THE INVENTION

A main objective of the present invention is to provide a power-on reset circuit (POR) having a null static power consumption and which is particularly insensitive to improper stimuli.

These objectives and other advantages are achieved by the circuit object of the present invention which is characterized by having a null static power consumption and an oustanding immunity to noise. Essentially the circuit comprises a first and a second inverter, connected in cascade, the output of the second inverter representing the output of the reset circuit. The interconnection node between the two inverters is capacitively coupled to ground potential while the input node of the first inverter is capacitively coupled to the supply voltage. A first switch, driven by the potential actually present on said interconnection node between the two inverters, is functionally connected between the input node of the first inverter and the supply rail and a second switch is functionally connected between the input node of the first inverter and ground. This second switch has a control terminal to which a driving signal which is tapped from a biasing line connected to the supply rail and comprising at least two forward biased junctions in series with each other and capacitively coupled to ground potential, is fed. The node of the biasing line capacitively coupled to ground is functionally connected to a control terminal of the second switch for determining a state of conduction or of interdiction.

The two forward biased and series-connected junctions of the biasing line may be realized by means of two diodes functionally connected in series and the connection node between the two series-connected diodes may also be capacitively coupled to ground potential.

Moreover, a discharge switch, controlled by the supply rail voltage is connected between said node of capacitive coupling to ground of the biasing line and ground in order to quickly reset to ground potential the node controlling said second switch upon switching-off of the power supply to the integrated circuit. This latter feature is not taught by EP-A-0 150 480.

A third switch may be connected between said intermediate node of the biasing line and a control terminal of the second switch and be driven by the signal present on the connection node between the two inverters, thus implementing, at the instant the first inverter triggers, a feedback which accelerates the discharge of the voltage present on the input node of the first inverter toward ground potential through the second switch, by increasing the potential present on said control node of the second switch toward the potential of the intermediate connection node of the biasing line, i.e. by eliminating the effect of the threshold of the second diode of the biasing line.

### BRIEF DESCRIPTION OF THE DRAWINGS

The different aspects and advantage will become more evident through the following description of a preferred embodiment and reference to the annexed drawings, wherein:
**Figure 1** is a circuit diagram of a power-on reset circuit of the invention;
**Figure 2** is a diagram showing the operating voltage characteristics relative to the significant nodes of the circuit of Fig. 1.

### DESCRIPTION OF THE BEST MODE

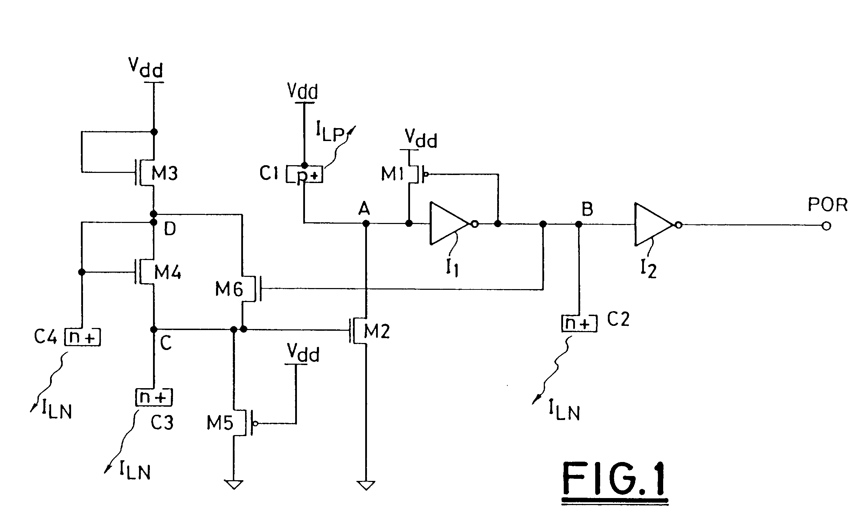

With reference to Fig. 1, the circuit of the invention readily integratable in a CMOS device comprises two inverters I1 and I2 connected in cascade. The circuit delivers a desired reset signal upon the switching on of the power to the integrated circuit through an output node POR. The input node A of the first inverter I1 is capacitively coupled to the supply node V_{dd} of the circuit through an integrated capacitor C1, which may be formed by a P-type diffusion formed in a N-well region electrically connected to the supply rail V_{dd}. The intermediate connection node B between the two inverters is capacitively coupled to ground by means of an integrated capacitor C2, which may be realized by an N-type diffusion formed in a P-type of the integrated circuit substrate which is electrically connected to ground potential. A first switch M1, which may be realized by means of a P-channel MOS transistor, is driven by the signal present on the node B and is functionally connected between the input node A of the first inverter I1 and the supply rail V_{dd}. A second switch M2 which may be realized by means of an N-channel MOS transistor, is functionally connected between the input node A of the first inverter I1 and ground and is driven by a driving signal which is derived from a node C of capacitive coupling to ground of a biasing line connected to the supply rail, and which comprises at least two diodes or two forward biased junctions in series with each other, which may be implemented by means of two diode-configured N-channel MOS transistors M3 and M4. Both the node C and the intermediate node D of the biasing line are capacitively coupled to the ground potential of the circuit through respective integrated capacitors C3 and C4. Also these integrated capacitors C3 and C4 may be realized by means of N-type diffusions formed in a P-type substrate of the integrated circuit, connected to ground potential.

Moreover, a third switch may optionally and most preferably be connected between the C node of the biasing line, notably from where the signal driving the M2 switch is derived, for discharging the voltage present on the C node upon the switching off of the power; i.e. when the supply voltage drops below the potential of the C node. In the example shown in Fig. 1, such a switch is constituted by the P-channel transistor M5 whose control terminal is connected to the supply rail of the circuit.

Optionally the circuit may also advantageously be provided with a feedback loop constituted by a fifth switch M6 functionally connected between the D and C nodes of the biasing line and which is driven by the signal present on the B node between the two inverters. As shown, this fifth switch may be constituted by an N-channel MOS transistor.

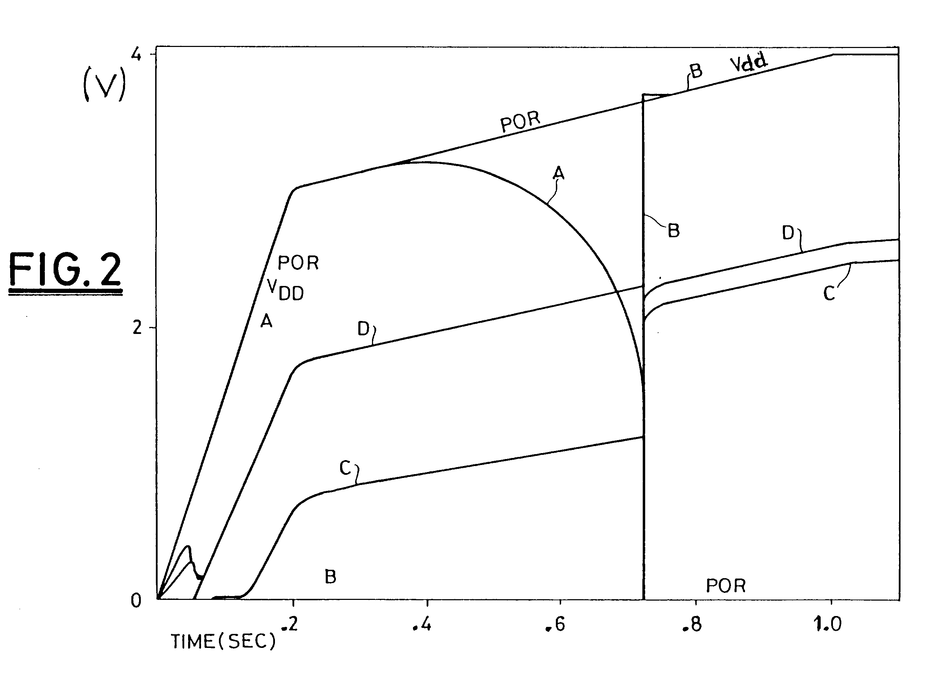

The operation of the circuit, as may be followed by observing the diagrams of Fig. 2, is as follows.

Before the power-on instant, all the circuital nodes are at ground potential and all the devices are in an "OFF" state.

Upon switching on power, the nodes D, C and B initially continue to be maintained at ground potential because of their strong capacitive coupling with the substrate; the persistence of the ground potential on said nodes being eventually favored also by the natural current leakage toward ground, schematically depicted in Fig. 1 by the arrows I_{LN}, which is normally present in an N-type junction formed in a P-type substrate connected to ground.

On the contrary, the node A follows the rise of the supply voltage because of the strong capacitive coupling of this node with the supply rail (V_{DD}), also this voltage rise following behaviour is favored by the natural current leakage toward the supply rail, schematically indicated in Fig. 1 by the arrow I_{LP}, which is intrinsically present through a P-type junction formed in an N-well region connected to V_{DD}, and subsequently also by the establishment of an active current path toward the supply rail through the P-channel transistor M1.

After such a first brief capacitance charging phase, the further rise of the supply voltage toward the design value, begins to be followed also by the nodes D and C of the biasing line, each at a certain "distance" from the actual supply voltage due to the threshold voltages of the diode-connected transistors M3 and M4.

When the potential of the C node rises beyond the threshold voltage of an integrated N-channel transistor, through the N-channel transistor M2 a discharge path toward ground of the potential present on the input node A of the first inverter I1 is created. The rise of the C node potential causes, upon the switching on of the M2 transistor, a progressive drop of the potential of the input node A of the first inverter I1 from the level which had previously reached through the capacitive coupling provided by the capacitor C1 during said first charging phase and subsequently through the active path provided by the M1 transistor. When the dropping potential on the A node reaches the triggering level of the inverter I1, the latter triggers thus bringing its output node potential, i.e. the node B of the circuit, to the full value of the supply voltage, which determines the ending of the resetting pulse POR, which had been provided until that moment by the circuit through its output terminal.

The POR pulse, which from the power-on instant had followed the actual voltage rise of the supply rail V_{DD}, switches to ground potential, thus terminating its action on the circuits integrated in the semiconductor device.

Simultaneously, the triggering up to the supply voltage of the potential on the B node of the circuit, by further activating the transistor M2, suddenly increases the potential level reached by the C node of the biasing line, thus enhancing the conditions which had lead to the new configuration (i.e. to the termination of the POR pulse).

This feedback action which is exerted through the node B on the M6 transistor, by substantially eliminating the effect on the potential reached by the C node due to the threshold of the M4 transistor, practically introduces an hysteresis which confers to the circuit an outstanting immunity against possible "rebounds" on the supply rail and/or internal noise. This effectively prevents the occurrence of spurious POR pulses which could otherwise take place as a consequence of an accidental drop of potential on the C node below the threshold level of the M2 transistor and produce an undesired spurious POR signal through the output terminal of the circuit.

The triggering level of the POR signal may be easily preestablished at the design stage by a relative dimensioning of the M1 and M2 transistors.

The M5 transistor permits to quickly discharge the C node and therefore also the D node of the biasing line, when the supply voltage drops below the level reached by the C node. This accelerates resetting after switching-off the integrated circuit. In practice, the transistor M5 may also be substituted by a diode, e.g. a P/N-well junction with the P-junction connected to the C node and the N-well connected to the supply rail. The action performed would be identical to that exerted by the transistor M5.

Of course the N and P diffusions which are used for realizing the capacitors C1, C2, C3 and C4 should have an area sufficiently large for establishing a strong capacitive coupling and cause relatively high leakage currents in order to optimize the operating conditions of the circuit.

## Claims

1. A power-on reset circuit having a null static consumption, capable of generating through an output a resetting signal which upon powering the integrated circuit follows the rise of the supply voltage up to the design value and thereafter stably switches to ground potential, comprising a biasing line connected to the supply rail (Vdd) and capacitively coupled to ground which includes at least two series-connected forward biased junctions (M3, M4), the node (C) of capacitive coupling to ground of the line being coupled to a control terminal of a first switch (M2) that is functionally connected between an input node (A) that is capacitively coupled to the supply rail (Vdd) and ground, a cascade-connected first and second inverters (I1, I2), the output of the second inverter constituting the output (POR) of the power-on reset circuit, the connection node (B) between the two inverters (I1, I2) being capacitively coupled to ground and the first inverter (I3) having an input coupled to said input node (A),
a second switch (M1) driven by the signal present on said connection node (B) between the inverters, functionally connected between said input node (A) and the supply rail (Vdd),
characterized in that it further comprises
a third switch (M5) driven by the supply voltage (Vdd) functionally connected between said node (C) of capacitive coupling to ground of said biasing line and ground.

2. The circuit as defined in claim 1, wherein said two forward biased junctions in series are constituted by two diodes (M3, M4) functionally connected in series, the connection node (D) between the two diodes in series being capacitively coupled to ground.

3. The circuit a defined in claim 1, wherein a fourth switch (M6) is connected between said connection node (D) between said two forward biased junctions (M3, M4) and said control terminal of said first switch (M2) and is driven by the signal present on the connection node (B) between said inverters (I1, I2), thus implementing, upon the triggering of said first inverter, a feedback action capable of enhancing the discharge of the voltage present on the input node (A) of the first inverter toward ground potential through said first switch (M2), thus raising the potential on the control terminal of said first switch toward the potential of said connection node (D) between said two junctions (M3, M4) of the biasing line.

4. The circuit as defined in claim 1, wherein said integrated circuit has a P-type substrate connected to ground and said capacitive couplings to ground are established by means of integrated capacitors (C2, C3, C4) of an N-diffusion/P-substrate type and said capacitive coupling to the supply rail (Vdd) is realized by means of an integrated capacitor (C1) of a P-diffusion/N-well type wherein said N-well region is connected to the supply rail (Vdd).

5. The circuit as defined in claim 4, wherein said first switch (M2) is an N-channel MOS transistor, said junctions connected in series of said biasing line are constituted by two diode-connected N-channel MOS transistors (M3, M4) and said second switch (M1) is a P-channel MOS transistor.

6. A circuit as defined in claim 1, wherein said third discharge switch (M5) which is controlled by the supply voltage (Vdd) is a P-channel MOS transistor capable of conducting when the supply voltage (Vdd) drops below the potential of said node (C) of capacitive coupling to ground of said biasing line.

7. The circuit as defined in claim 3, wherein said fourth switch (M6) is an N-channel MOS transistor.

## Patentansprüche

1. Einschaltrücksetzschaltung mit statischem Nullverbrauch, welche in der Lage ist, über einen Ausgang ein Rücksetzsignal zu erzeugen, welches beim Versorgen der integrierten Schaltung dem Anstieg der Zufuhrspannung bis zu dem Auslegungswert folgt, und nachfolgend stabil auf Erdungpotential schaltet, umfassend eine Vorspannleitung, welche mit der Zufuhrschiene (Vdd) verbunden und kapazitiv mit Erdung gekoppelt ist, welche zumindest zwei in Serie geschaltete vorwärtig vorgespannte Verbindungspunkte (M3, M4) umfaßt, wobei der Knoten (C) der kapazitiven Kopplung mit Erdung der Leitung mit einem Steueranschluß eines ersten Schalters (M2) gekoppelt ist, welcher funktionell geschaltet ist zwischen einen Eingangsknoten (A), welcher kapazitiv gekoppelt ist mit der Zufuhrschiene (Vdd) und Erdung, kaskadiert geschaltete erste und zweite Inverter (I1, I2), wobei der Ausgang des zweiten Inverters den Ausgang (POR) der Einschaltrücksetzschaltung bildet, wobei der Verbindungsknoten (B) zwischen den zwei Invertern (I1, I2) kapazitiv gekoppelt ist mit Erdung, und wobei der erste Inverter (I3) einen Eingang gekoppelt mit dem Eingangsknoten (A) aufweist,
einen zweiten Schalter (M1), welcher durch das Signal angetrieben ist, welches an dem Verbindungsknoten (B) zwischen den Invertern vorliegt, welcher funktionell geschaltet ist zwischen den Eingangsknoten (A) und die Zufuhrschiene (Vdd),
**dadurch gekennzeichnet**, daß sie des weiteren umfaßt
einen dritten Schalter (M5), welcher durch die Zufuhrspannung (Vdd) angetrieben wird, funktionell geschaltet zwischen den Knoten (C) der kapazitiven Kopplung mit Erdung der Vorspannleitung und Erdung.

2. Schaltung nach Anspruch 1, bei welcher die zwei vorwärtig vorgespannten Verbindungspunkte in Serie gebildet sind durch zwei Dioden (M3, M4), funktionell in Serie geschaltet, wobei der Verbindungsknoten (D) zwischen den zwei Dioden in Serie kapazitiv mit Erdung gekoppelt ist.

3. Schaltung nach Anspruch 1, bei welcher ein vierter Schalter (M6) geschaltet ist zwischen den Verbindungsknoten (D) zwischen den zwei vorwärtig vorgespannten Verbindungspunkten (M3, M4) und den Steueranschluß des ersten Schalters (M2), und angetrieben ist durch das Signal, welches an dem Verbindungsknoten (B) zwischen den Invertern (I1, I2) vorliegt, wodurch beim Triggern des ersten Inverters eine Rückkopplungswirkung implementiert wird, welche in der Lage ist, die Entladung der Spannung zu erhöhen, welche an dem Eingangsknoten (A) des ersten Inverters vorliegt, hin zu Erdungspotential über den ersten Schalter (M2), wodurch das Potential an dem Steueranschluß des ersten Schalters hin zu dem Potential des Verbindungsknotens (D) zwischen den zwei Verbindungspunkten (M3, M4) der Vorspannleitung erhöht wird.

4. Schaltung nach Anspruch 1, bei welcher die integrierte Schaltung ein P-Typ Substrat aufweist, welches mit Erdung verbunden ist, wobei die kapazitiven Kopplungen mit Erdung gebildet sind mittels integrierten Kapazitäten (C2, C3, C4) von einem N-Diffusion/P-Substrattyp, und wobei die kapazitive Kopplung mit der Zufuhrschiene (Vdd) erreicht wird mittels einer integrierten Kapazität (C1) eines P-Diffusion/N-Donator-Types, wobei der N-Donatorbereich mit der Zufuhrschiene (Vdd) verbunden ist.

5. Schaltung nach Anspruch 4, bei welcher der erste Schalter (M2) ein N-Kanal MOS-Transistor ist, wobei die Verbindungspunkte, in Serie geschaltet, der Vorspannleitung, gebildet sind durch zwei diodengeschaltete N-Kanal MOS.Transistoren (M3, M4), und wobei der zweite Schalter (M1) ein P-Kanal MOS-Transistor ist.

6. Schaltung nach Anspruch 1, bei welcher der dritte Entladungsschalter (M5), welcher gesteuert ist durch die Zufuhrspannung (Vdd), ein P-Kanal MOS-Transistor ist, welcher in der Lage ist, zu leiten, wenn die Zufuhrspannung (Vdd) unter das Potential des Knotens (C) der kapazitiven Kopplung mit Erdung der Vorspannleitung fällt.

7. Schaltung nach Anspruch 3, bei welcher der vierte Schalter (M6) ein N-Kanal MOS-Transistor ist.

## Revendications

1. Circuit de remise à zéro à la mise sous tension ayant une consommation statique nulle, capable de produire sur une sortie un signal de remise à zéro qui, par suite de la mise sous tension du circuit intégré, suit la croissance de la tension d'alimentation jusqu'à la valeur nominale et commute ensuite de façon stable au potentiel de la masse, comprenant une ligne de polarisation connectée au rail d'alimentation (Vdd) et couplée capacitivement à la masse, qui comprend au moins deux jonctions polarisées en direct connectées en série (M3, M4), le noeud (C) de couplage capacitif à la masse de la ligne étant couplé à une borne de commande d'un premier commutateur (M2) qui est fonctionnellement connecté entre un noeud d'entrée (A) qui est capacitivement couplé au rail d'alimentation (Vdd) et à la masse, des premier et second inverseurs connectés en cascade (I1, I2), la sortie du deuxième inverseur constituant la sortie (POR) du circuit de remise à zéro à la mise sous tension, le noeud de connexion (B) entre les deux inverseurs (I1, I2) étant couplé capacitivement à la masse et le premier inverseur (I3) ayant une entrée couplée au noeud d'entrée (A), et un second commutateur (M1) piloté par le signal présent sur le noeud de connexion (B) entre les inverseurs, fonctionnellement connecté entre le noeud d'entrée (A) et le rail d'alimentation (Vdd),
caractérisé en ce qu'il comprend en outre un troisième commutateur (M5) piloté par la tension d'alimentation (Vdd), fonctionnellement connecté entre le noeud (C) de couplage capacitif à la masse de la ligne de polarisation et la masse.

2. Circuit selon la revendication 1, dans lequel les deux jonctions polarisées en direct, en série, sont constituées de deux diodes ((M3, M4) fonctionnellement connectées en série, le noeud de connexion (D) entre les deux diodes en série étant capacitivement couplé à la masse.

3. Circuit selon la revendication 1, dans lequel un quatrième commutateur (M6) est connecté entre le noeud de connexion (D) entre les deux jonctions polarisées en direct (M3, M4) et la borne de commande du premier commutateur (M2) et est piloté par le signal présent sur le noeud de connexion (B) entre les inverseurs (I1, I2), réalisant ainsi, par suite du déclenchement du premier inverseur, une action de réaction apte à renforcer la décharge de la tension présente sur le noeud (A) du premier inverseur vers le potentiel de la masse à travers le premier commutateur (M2), élevant ainsi le potentiel sur la borne de commande du premier commutateur vers le potentiel du noeud de connexion (D) entre les deux jonctions (M3, M4) de la ligne de polarisation.

4. Circuit selon la revendication 1, dans lequel le circuit intégré comprend un substrat de type P connecté à la masse et dans lequel les couplages capacitifs vers la masse sont établis au moyen de condensateurs intégrés (C2, C3, C4) du type diffusion-N/substrat-P et le couplage capacitif vers le rail d'alimentation (Vdd) est réalisé par un condensateur intégré (C1) de type diffusion-P/caisson-N dans lequel la région de caisson N est connectée au rail d'alimentation (Vdd).

5. Circuit selon la revendication 4, dans lequel le premier commutateur (M2) est un transistor MOS à canal N, les jonctions connectées en série de la ligne de polarisation sont constituées de deux transistors MOS à canal N connectés en diodes (M3, M4), et le second commutateur (M1) est un transistor MOS à canal P.

6. Circuit selon la revendication 1, dans lequel le troisième commutateur de décharge (M5) qui est commandé par la tension d'alimentation (Vdd) est un transistor MOS à canal P apte à conduire quand la tension d'alimentation (Vdd) chute sous le potentiel du noeud (C) de couplage capacitif vers la masse de la ligne de polarisation.

7. Circuit selon la revendication 3, dans lequel le quatrième commutateur (M6) est un transistor MOS à canal N.
